# EUROPEAN PATENT APPLICATION

(11) **EP 4 815 031 A1**
(43) Date of publication of application: **30.09.2026**
(21) Application number: 24893942.3
(22) Date of filing: 28.10.2024
(51) Int. Cl.: H01L 21/02, H01L 21/203

(54) **BONDED SEMICONDUCTOR SUBSTRATE AND METHOD FOR MANUFACTURING BONDED SEMICONDUCTOR SUBSTRATE**

(30) Priority: 22.11.2023 JP 2023198241
(71) Applicant: SUMITOMO METAL MINING CO., LTD., Tokyo 105-8716 (JP)
(72) Inventor: SAKAMOTO, Minoru, Tokyo 105-0004 (JP); NISHIMURA, Eiichiro, Tokyo 105-0004 (JP)
(74) Representative: TBK
(86) International application number: PCT/JP2024/038314
(87) International publication number: WO 2025/109949

(57) **Abstract**

Provided are a bonded semiconductor substrate and a method for manufacturing the bonded semiconductor substrate, which can ensure sufficient bonding strength between a first semiconductor substrate and a second semiconductor substrate and can suppress the occurrence of bonding defects caused by pits on a bonding target surface.

A method for manufacturing a bonded semiconductor substrate comprising a first semiconductor substrate and a second semiconductor substrate in contact with the first semiconductor substrate, comprising: an amorphous layer deposition step of depositing an amorphous layer having the same composition as the first semiconductor substrate on at least one of a first bonding target surface, which is the surface of the first semiconductor substrate where the first semiconductor substrate is bonded to the second semiconductor substrate, or a second bonding target surface, which is the surface of the second semiconductor substrate where the second semiconductor substrate is bonded to the first semiconductor substrate; a bonding step of bonding the first bonding target surface and the second bonding target surface after the amorphous layer deposition step to form a bonded substrate having a bonding interface; and a heat treatment step of heat treating the bonded substrate, wherein the amorphous layer deposition step and the bonding step are performed in the same apparatus.

## Description

### Technical Field

The present invention relates to a bonded semiconductor substrate and a method for manufacturing a bonded semiconductor substrate.

### Background Art

Silicon carbide (hereinafter sometimes referred to as "SiC") is an example of a substrate material for power devices. However, the manufacturing cost of SiC single crystal substrates themselves is high, which is an obstacle to the practical use of SiC single crystal substrates alone. In response to this, bonded semiconductor substrates have been developed in which high-quality SiC single crystal substrates are used only for the device layers, and low-cost support substrates such as SiC polycrystalline substrates are used for the remaining portions to reinforce the SiC single crystal substrate. For example, Patent Literature 1 discloses technology related to bonded semiconductor substrates.

When a SiC polycrystalline substrate is used as a support substrate in a bonded semiconductor substrate, the SiC polycrystalline substrate has various plane orientations on its surface, and therefore, when attempting to planarize the surface by CMP, the etching rate varies depending on the plane orientation, which is significantly affected by the crystal grains, resulting in a decrease in surface flatness. In this state, when the surface of the SiC polycrystalline substrate is bonded to the highly flat surface of a SiC single crystal substrate, gaps are generated at the bonding interface, resulting in poor bonding.

For this reason, Patent Literature 1 proposes irradiating the surfaces of the SiC single crystal substrate and the SiC polycrystalline substrate with a neutral argon atomic beam using a FAB gun (fast atom beam gun) to provide a bonding surface with high bonding strength even for SiC polycrystalline substrates, which are difficult to flatten to the same degree as the surface of a SiC single crystal substrate. This irradiation amorphizes the surfaces of the SiC single crystal substrate and the SiC polycrystalline substrate, and after bonding the SiC single crystal substrate and the SiC polycrystalline substrate, heat treatment is performed to crystallize the amorphized layer to obtain a bonded semiconductor substrate.

### Citation List

### Patent Literature

Patent Literature 1: JP 6061251 B
Patent Literature 2: JP 2009-117533 A1

### Summary of the Invention

### Problem to be Solved by the Invention

In the method of Patent Literature 1, by directly bonding a SiC single crystal substrate and a SiC polycrystalline substrate, the bonding strength at the bonded interface can be improved and the occurrence of bond defects can be reduced.

However, in Patent Literature 1, the surface of the SiC polycrystalline substrate used as the support substrate is polished to reduce the surface roughness before bonding to the SiC single crystal substrate. However, even so, a plurality of pits remains on the polished surface of the SiC polycrystalline substrate, which may cause portions of the bonded interface to become poorly bonded after bonding.

In order to solve the above problems, the present invention aims to provide a bonded semiconductor substrate obtained by bonding a first semiconductor substrate and a second semiconductor substrate, which ensures sufficient bonding strength between the first semiconductor substrate and the second semiconductor substrate and can suppress bonding defects caused by pits on the surface of bonded surface, and a method for manufacturing such a bonded semiconductor substrate.

### Solution to Problem

To solve the above-mentioned problems, the present invention provides a method for manufacturing a bonded semiconductor substrate comprising a first semiconductor substrate and a second semiconductor substrate in contact with the first semiconductor substrate, the method comprising: an amorphous layer deposition step of depositing an amorphous layer having the same composition as the first semiconductor substrate on at least one of a first bonding target surface, which is the surface of the first semiconductor substrate where the first semiconductor substrate is bonded to the second semiconductor substrate, or a second bonding target surface, which is the surface of the second semiconductor substrate where the second semiconductor substrate is bonded to the first semiconductor substrate; a bonding step of bonding the first bonding target surface and the second bonding target surface after the amorphous layer deposition step to form a bonded substrate having a bonding interface; and a heat treatment step of heat treating the bonded substrate, wherein the amorphous layer deposition step and the bonding step are performed in the same apparatus.

The first semiconductor substrate and the second semiconductor substrate may be made of any of silicon carbide (SiC), silicon (Si), carbon (C), gallium nitride (GaN), aluminum nitride (AlN), gallium oxide (Ga₂O₃), and diamond, and the first semiconductor substrate may be polycrystalline and the second semiconductor substrate may be single crystal.

The amorphous layer deposition step may be a step of depositing the amorphous layer on at least one of the first bonding target surface or the second bonding target surface by sputtering.

The method for manufacturing a bonded semiconductor substrate may comprise, before the amorphous layer deposition step, an oxide removal step of removing at least one of the oxides on the first bonding target surface and the second bonding target surface.

The oxide removal step may be a step of removing at least one of the oxides on the first bonding target surface and the second bonding target surface by a sputtering method using at least one of the first bonding target surface and the second bonding target surface as a target.

The heat treatment step may be a step of maintaining the temperature of the bonded substrate at 1500°C to 2200°C.

The method for manufacturing a bonded semiconductor substrate may comprise, before the amorphous layer deposition step, an ion implantation step of implanting hydrogen ions or helium ions into the second bonding target surface to form an ion-implanted layer inside the second semiconductor substrate.

The method for manufacturing a bonded semiconductor substrate may comprise a delamination step after the bonding step and before the heat treatment step, wherein the delamination step is a step of delaminating a portion of the second semiconductor substrate using a microbubble layer formed by heating the ion implanted layer as a delamination surface.

The amorphous layer deposition step may be a step of depositing an amorphous layer having a thickness of 10 nm to 30 nm.

To solve the above problem, the present invention provides a bonded semiconductor substrate comprising a first semiconductor substrate and a second semiconductor substrate bonded to the first semiconductor substrate via a bonding interface, wherein the bonded semiconductor substrate is disk-shaped with a diameter of 100 to 210 mm, and wherein the number of bonding defects at the bonded interface is 0.05 pcs/cm² or less.

### Effects of the Invention

The present invention provides a bonded semiconductor substrate obtained by bonding a first semiconductor substrate and a second semiconductor substrate, which ensures sufficient bonding strength between the first semiconductor substrate and the second semiconductor substrate and can suppress bonding defects caused by pits on the surface of bonded surface, and a method for manufacturing such a bonded semiconductor substrate.

### Brief description of the drawings

[Figure 1] A flow diagram illustrating an example of a method for manufacturing a bonded semiconductor substrate of the present invention.
[Figure 2] A schematic perspective view illustrating an example of a bonded semiconductor substrate of the present invention.
[Figure 3] A schematic side view of a single crystal substrate after formation of a hydrogen implanted layer of the present invention.
[Figure 4] A schematic side view of a single crystal substrate after deposition of an amorphous layer of the present invention.
[Figure 5] An explanatory diagram illustrating an example of an oxide removal step, an amorphous layer deposition step, and a bonding step of the present invention.
[Figure 6] A schematic side view of an example of a bonded substrate after the bonding step but before the delamination step.
[Figure 7] A schematic side view of an example of a bonded substrate after the delamination step but before the heat treatment step.

### Detailed Description of Embodiments

This specification discloses a bonded semiconductor substrate and a method for manufacturing a bonded semiconductor substrate. A bonded semiconductor substrate is characterized by being obtained by depositing an amorphous layer on at least one of the surfaces of a first semiconductor substrate and a second semiconductor substrate, bonding these semiconductor substrates together to form a bonded substrate having a bonded interface, and then recrystallizing the amorphous layer through a subsequent heat treatment.

An example of an embodiment of the present invention is described below with reference to the drawings.

### [Bonded Semiconductor Substrate]

A bonded semiconductor substrate includes a first semiconductor substrate and a second semiconductor substrate. The first semiconductor substrate and the second semiconductor substrate are bonded via a bonded interface.

### <Configuration of the Bonded Semiconductor Substrate>

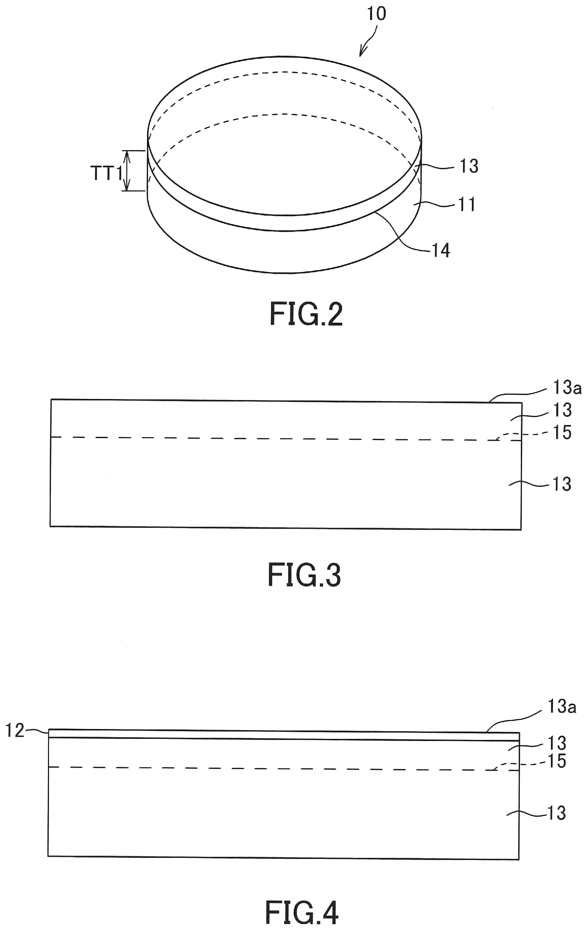

Figure 2 is a perspective view showing an example of a bonded semiconductor substrate of the present invention. The bonded semiconductor substrate 10 of the present invention is formed, for example, in a disk shape with an orientation flat. The bonded semiconductor substrate 10 includes a support substrate 11, which is an example of a first semiconductor substrate, and a single crystal substrate 13, which is an example of a second semiconductor substrate. The single crystal substrate 13 is bonded to the support substrate 11 to form a bonded interface 14.

The single crystal substrate 13 may be, for example, a compound semiconductor (e.g., silicon carbide (SiC), gallium nitride (GaN), aluminum nitride (AlN), gallium oxide (Ga₂O₃)), a single-element semiconductor (e.g., silicon (Si)), carbon (C)), or diamond. These elements are semiconductor materials useable for semiconductor device fabrication. Note that the carbon (C) may be other than diamond, such as graphite.

Various materials can be used for the support substrate 11. It is preferable that the support substrate 11 be resistant to the various thermal steps applied to the single crystal substrate 13. For example, the support substrate 11 can be made of any of silicon carbide (SiC), silicon (Si), carbon (C), gallium nitride (GaN), aluminite (AlN), gallium oxide (Ga₂O₃), diamond, sapphire (Al₂O₃), and quartz (SiO₂). Note that the carbon (C) may be other than diamond, such as graphite.

Furthermore, the support substrate 11 is preferably made of a material with a small difference in thermal expansion coefficient from the single crystal substrate 13. Therefore, the support substrate 11 is preferably a polycrystalline substrate made of the same material as the single crystal substrate 13. For example, the single crystal substrate 13, which is an example of the second semiconductor substrate, may be a single crystal silicon carbide substrate (a SiC single crystal substrate), and the support substrate 11, which is an example of the first semiconductor substrate, may be a polycrystalline silicon carbide substrate (a SiC polycrystalline substrate).

The SiC single crystal substrate may be, for example, a 4H-SiC single crystal substrate fabricated by sublimation deposition. The SiC single crystal substrate may be, for example, approximately disc-shaped with an orientation flat and a diameter of 4 to 8 inches (100 to 210 mm).

The SiC polycrystalline substrate may also contain a mixture of SiC crystals of various polytypes and plane orientations. A SiC polycrystalline substrate with a mixture of various polytypes and plane orientations can be manufactured without strict temperature control, thereby reducing the cost of manufacturing the support substrate 11. For example, a 3C-SiC polycrystalline substrate obtained by depositing a SiC polycrystalline film by chemical vapor deposition can be used. The shape of the SiC polycrystalline substrate may be approximately the same as that of a SiC single crystal substrate. For example, a roughly disk-shaped substrate with an orientation flat and a diameter of 4 to 8 inches (100 to 210 mm) can be used.

The thickness TT1 of the support substrate 11 may be determined so as to provide sufficient mechanical strength to withstand subsequent processing steps, such as the formation of an epitaxial layer and the subsequent formation of semiconductor elements and devices thereon. For example, if the diameter of the support substrate 11 is 6 inches (approximately 150 mm), the thickness TT1 may be approximately 350 µm, and a substrate with a thickness TT1 of 300 to 500 µm can be used.

The bonded semiconductor substrate 10 is disk-shaped with a diameter of 4 to 8 inches (100 to 210 mm), and the number of bond defects at the bonded interface 14 is 0.05 pcs/cm2 or less. For example, the number of bond defects in a 4-inch diameter bonded semiconductor substrate is 4 pcs or less, the number of bond defects in a 6-inch diameter bonded semiconductor substrate is 7 pcs or less, and the number of bond defects in an 8-inch diameter bonded semiconductor substrate is 12 pcs or less.

Bond defects at the bonded interface 14 refer to a state in which a gap occurs at the bonded interface, preventing the first and second semiconductor substrates from bonding together. For example, multiple pits present on the polished surface of a SiC polycrystalline substrate can cause bond defects at the bonded interface after bonding.

Here, the bond defects can be measured using a wafer surface defect inspection device and are expressed in the form of defect density (pcs/cm²), which can be calculated by dividing the number of voids (<8 pcs) formed at the interface between the single crystal substrate and the polycrystalline substrate detected within the area of the effective area on the single crystal substrate where devices can be fabricated (e.g., 161 cm² for a 6-inch substrate) by the area of that effective area. Note that bond defects are defined as areas with a diameter of 10 µm or more.

### [Method for Manufacturing a Bonded Semiconductor Substrate]

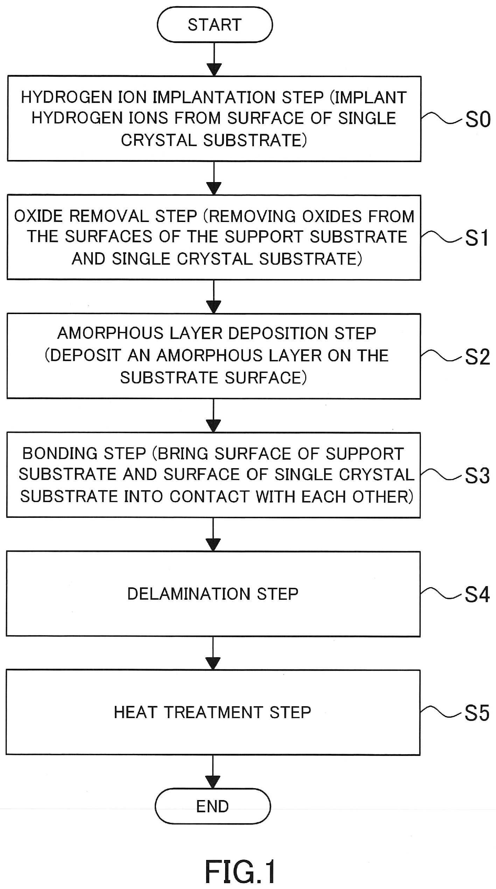

Next, as an example of a method for manufacturing a bonded semiconductor substrate comprising a first semiconductor substrate and a second semiconductor substrate according to the present invention, a method for manufacturing a bonded semiconductor substrate 10 in which the support substrate 11, which is the first semiconductor substrate, is a SiC polycrystalline substrate and the single crystal substrate 13, which is the second semiconductor substrate, is a 4H-SiC single-crystal substrate, will be described. Here, with reference to the flow diagram showing an example of a method for manufacturing a bonded semiconductor substrate shown in FIG. 1, the manufacturing of the bonded semiconductor substrate 10 will be described using a technique for delaminating the single crystal substrate 13 by ablation of hydrogen atoms.

The first and second semiconductor substrates may be made of any of silicon carbide (SiC), silicon (Si), carbon (C), gallium nitride (GaN), aluminum nitride (AlN), gallium oxide (Ga₂O₃), and diamond. Note that the carbon (C) may be other than diamond, such as graphite.

The first semiconductor substrate may be polycrystalline, and the second semiconductor substrate may be single crystal. When a SiC single crystal substrate is used for the single crystal substrate 13, it is not limited to 4H-SiC single crystal substrates, and various polytypes of SiC single crystal substrates, such as 3C-SiC and 6H-SiC, can be used as the single crystal substrate 13. When a SiC polycrystalline substrate is used for the support substrate 11, it is not limited to 3C-SiC polycrystalline substrates, and various polytypes of SiC polycrystalline substrates can be used.

First, the support substrate 11 and the single crystal substrate 13 are prepared. The support substrate 11 and the single crystal substrate 13 can be purchased with their bonding target surfaces already planarized. Planarization may be performed by grinding or cutting, or by CMP. Alternatively, the bonding target surfaces may be planarized manually.

### <Hydrogen Ion Implantation Step (Step S0)>

In step S0 of FIG. 1, hydrogen ions are implanted into the bonding target surface 13a of the single crystal substrate 13. When hydrogen ions are implanted into the single crystal substrate 13, they reach a depth corresponding to the incident energy and become highly concentrated. As a result, a hydrogen implanted layer 15, indicated by the dotted line, is formed at a predetermined depth from the bonding target surface 13a, as shown in the side view schematic diagram of FIG. 3. For example, the hydrogen implanted layer 15 is formed at a depth of approximately 0.6 µm from the bonding target surface 13a.

Helium ions may be implanted instead of hydrogen to form a helium implanted layer. Alternating hydrogen and helium ion implantations can also be used to form an implanted layer, and similar delamination effects can be expected in the delamination step described below.

The hydrogen ion implantation step is not essential to the present invention. Alternatively, a hydrogen ion implanted single crystal substrate 13 may be purchased and used to practice the present invention.

The hydrogen ion implantation step can be employed, for example, when the first semiconductor substrate is a SiC polycrystalline substrate and the second semiconductor substrate is a SiC single crystal substrate, or when the first semiconductor substrate is a Si substrate and the second semiconductor substrate is a Si substrate. It can be performed before or after the amorphous layer deposition step described below.

### <Oxide Removal Step (Step S1)>

This step removes at least one of the oxides on the first bonding target surface 11a and the oxides on the second bonding target surface 13a before the amorphous layer deposition step. By removing the oxide, bonds such as Si and C can be exposed on the first bonding target surface 11a and the second bonding target surface 13a, thereby enabling a stronger bond between the first semiconductor substrate and the second semiconductor substrate.

The specific method for the oxide removal step is not particularly limited as long as it is capable of removing oxides from the first bonding target surface 11a or oxides from the second bonding target surface 13a. For example, a method can be used in which atoms or molecules collide with the first bonding target surface or the second bonding target surface to remove oxides or adsorption layers from these surfaces through a sputtering phenomenon, or a method can be used in which a reactive gas chemically reacts with the oxides on the first bonding target surface or the second bonding target surface to remove them by etching.

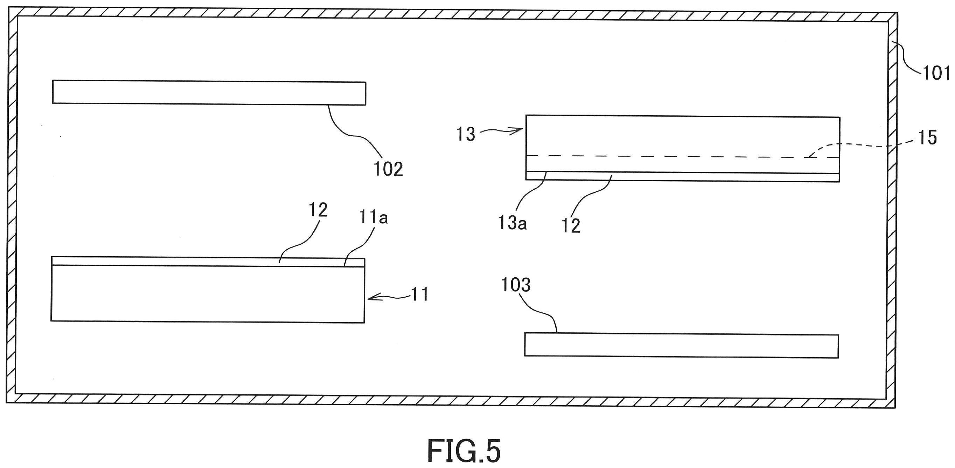

In the present invention, if sputtering is used in the subsequent amorphous layer deposition step, it is preferable to also use sputtering to remove oxides in the oxide removal step. That is, at least one of the first bonding target surface 11a and the second bonding target surface 13a may be used as a target, and at least one of the oxides on the first surface to be joined or the oxides on the second surface to be joined may be removed by sputtering. Specifically, the oxides may be removed by irradiating the bonding target surface 11a or the bonding target surface 13a with argon ions, rather than the target material (FIG. 5).

The oxide removal step is performed in step S1 of Fig. 1. For example, as shown in Fig. 5, single crystal substrate 13 and support substrate 11 are placed in chamber 101 of a sputtering device and are processed by facing sputtering targets 102 and 103, respectively. For example, by setting the argon ion output to 0.5 kW to 2.0 kW, which is lower than that of a typical sputtering method and irradiating at least one of bonding target surfaces 11a and 13a with argon ions, oxides adhering to these surfaces can be removed. The degree of vacuum in chamber 101 may be, for example, about 10 to 1 x 10⁻² Pa.

Furthermore, by performing the oxide removal step and the subsequent amorphous layer deposition step using sputtering, and performing these steps consecutively within the same equipment, these steps are performed in a vacuum. Therefore, the bonding target surfaces 11a and 13a can be deposited with the amorphous layer while maintaining their active state without oxidation, thereby preventing bonding defects caused by oxides. This shortens manufacturing time and enables stronger bonding between the first and second semiconductor substrates.

The oxide removal step is not essential and can be omitted if the two substrates can be bonded to form the bonded semiconductor substrate 10 without any problems in the bonding step described below. Furthermore, if oxides are present on only one of the first bonding target surface 11a and the second bonding target surface 13a, the oxide removal step need only be performed on that surface; it is not necessary to perform the step on both surfaces.

### <Amorphous Layer Deposition Step (Step S2)>

This step is a step of depositing an amorphous layer 12 having the same composition as the first semiconductor substrate on the first bonding target surface of the first semiconductor substrate or the second bonding target surface of the second semiconductor substrate, or on both surfaces thereof. That is, this step deposits and laminates an amorphous layer 12 on at least one of the bonding target surfaces 11a and 13a. Alternatively, an amorphous layer 12 may be deposited on both the bonding target surfaces 11a and 13a.

In FIG. 1, in step S2, an amorphous layer 12 is deposited on the bonding target surface 13a of the single crystal substrate 13. The amorphous layer 12 has no regularity in the arrangement of its constituent elements; that is, it is not crystalline, but rather a layer in which elements are irregularly arranged.

Physical vapor deposition is preferably used to deposit the amorphous layer 12. Examples include evaporation and sputtering.

In the present invention, atomic diffusion bonding is performed in the subsequent bonding step. Patent Literature 1 discloses a method in which the surfaces of a single crystal substrate and a polycrystalline substrate are amorphized by irradiating them with a neutral argon atomic beam using a FAB gun and then heat-treating the amorphized layer to crystallize and bond them. However, the method described in Patent Literature 1 involves amorphizing the surface of these substrates, which limits the thickness of the amorphous layer that can be formed. In Patent Literature 1, for example, the thickness of the amorphous layer is 2 nm. Therefore, if pits or other defects occur on the surface of a polycrystalline substrate, the pits may remain even after bonding the single crystal substrate and the polycrystalline substrate, resulting in poor bonding.

The bonding step of the present invention, like Patent Literature 1, is atomic diffusion bonding, which is a direct bonding step at room temperature, but the amorphous layer is deposited by physical vapor deposition and then directly bonded. Because room-temperature bonding can be used as the bonding step, a heating step is not required, and warping of the substrate due to thermal stress does not occur, facilitating high-precision bonding. Furthermore, covalent bonding at the atomic level provides strong bonding strength, resulting in excellent reliability and durability as a bonded semiconductor substrate. Furthermore, because the amorphous film is deposited by physical vapor deposition, the amorphous layer can be deposited to any desired thickness, thereby reducing the occurrence of bonding defects due to surface roughness at the bonding surface compared to Patent Literature 1 method. Details will be described later.

As a physical vapor deposition method, sputtering is particularly preferred because it allows the amorphous layer to be deposited with a uniform thickness across the entire surface to be deposited. Commercially available sputtering equipment can be used for sputtering.

It is preferable that the amorphous layer 12 be composed of the same composition as the support substrate 11. This composition maintains strong bonding strength, reduces distortion at the bonding interface during bonding, and suppresses substrate warping during heat treatment in the semiconductor device manufacturing process due to differences in linear expansion coefficients. Furthermore, since the optical properties of the amorphous layer 12 can be matched to those of the support substrate 11, noise from the bonded interface during optical defect inspection of the final bonded semiconductor substrate 10 can be reduced, ensuring accurate defect detection. When the support substrate 11 is polycrystalline SiC, the amorphous layer 12 is preferably composed of SiC with the same composition as the support substrate 11.

As an example of an embodiment of the present invention, a method for depositing the amorphous layer 12 by sputtering deposition using a sputtering method will be described in detail.

First, as shown in FIG. 5, the single crystal substrate 13 and the support substrate 11 are placed in a chamber 101, and the respective substrates are placed facing sputtering targets 102 and 103 for sputtering. Considering the sputtering yield, as a sputtering target, a SiC target can be used that provides a Si:C ratio of approximately 1:1 in the SiC of the amorphous layer to be deposited. The Si:C ratio of the SiC target may be adjusted as appropriate. For example, a SiC target with a Si-rich composition may be used. An amorphous layer formed using a SiC target with a Si-rich composition allows the heating temperature in the heat treatment step for diffusing and polycrystallizing the amorphous layer to be lower than the softening point of the polycrystalline substrate, making it more preferable to use a SiC target with a Si-rich composition.

The atmosphere within chamber 101 during the deposition step of the amorphous layer is vacuum, and the degree of vacuum may be, for example, approximately 10 to 1 × 10⁻² Pa. The power output is 0.5 to 5.0 kW, and can be set to, for example, 1 kW.

Furthermore, in order to control the conductivity, at least one of nitrogen (N), phosphorus (P), and boron (B) can be added to the amorphous layer. For example, nitrogen (N) can be added to the amorphous layer by introducing 0.1 to 50 volume % of nitrogen (N) into the atmosphere in the chamber 101 in addition to the inert gas argon (Ar) before sputtering deposition.

The thickness of the deposited amorphous layer is preferably 10 nm or more. For example, a 5 nm amorphous layer may be formed on each of the bonding target surfaces 11a and 13a, for a total thickness of 10 nm, or a 10 nm amorphous layer may be formed on only one of the surfaces. While there is no upper limit to the thickness of the amorphous layer, a thickness of 30 nm or less is preferred, considering the productivity of the sputtering step.

By depositing such an amorphous layer 12, elements in the amorphous layer 12 are more likely to migrate during the subsequent heat treatment step, which can facilitate the migration of elements into pits in the SiC polycrystalline substrate of the support substrate 11 and fill the pits. As a result, bonding defects can be suppressed.

For example, when an amorphous layer 12 is formed on a single crystal substrate 13, a structure in which the amorphous layer 12 is deposited on the surface of the single crystal substrate 13 is formed, as shown in the side view schematic diagram of Figure 4.

### <Bonding Step (Step S3)>

This step is a step in which the first and second bonding target surfaces are bonded together after the amorphous layer deposition step to form a bonded substrate having a bonding interface.

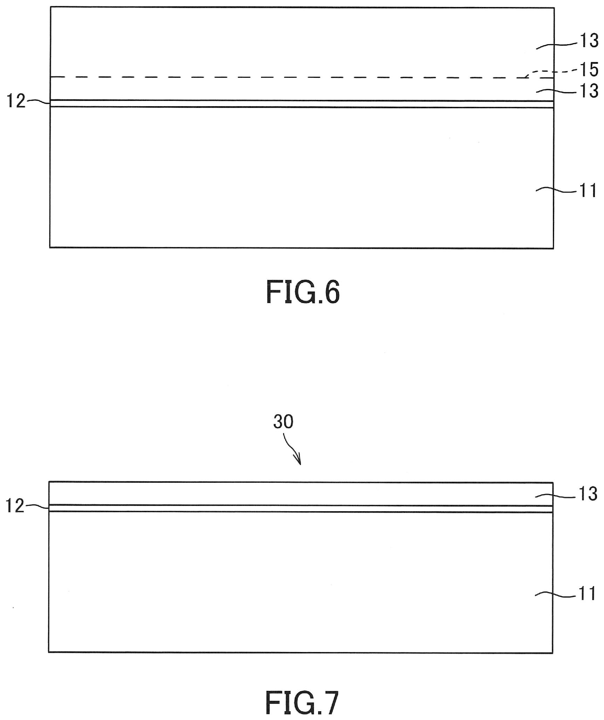

The bonding step is performed in step S3 of Figure 1. In the bonding step, for example, the bonding target surface 11a of the support substrate 11, on which the amorphous layer 12 is deposited, and the bonding target surface 13a of the single crystal substrate 13 is aligned in the chamber 101 and then brought into contact in a vacuum. As a result, the bonds present on the activated bonding target surfaces 11a and 13a are bonded to each other, and the support substrate 11 and the single crystal substrate 13 can be bonded together. As a result, a bonded structure is formed between the support substrate 11 and the single crystal substrate 13, as shown in the schematic diagram of FIG. 6.

The bonding temperature may be room temperature, and the bonding pressure may be sufficient to suppress warping of the substrates and ensure flatness. For example, a pressure of 100 N to 500 N may be used.

It is preferable that the bonding step and the amorphous layer deposition step be performed as a continuous step within the same apparatus. This allows the amorphous layer deposition step and the bonding step to be performed consecutively under the same vacuum conditions, ensuring stable bonding while maintaining the active state of the amorphous layer 12 on the bonding target surfaces 11a and 13a without oxidation.

Furthermore, the oxide removal step, amorphous layer deposition step, and bonding step may be performed consecutively in the same apparatus. This allows consecutive processing in a vacuum, allowing the amorphous layer 12 to be deposited and bonded while maintaining the active state of the bonding target surfaces 11a and 13a without oxidation, thereby preventing bonding defects caused by oxides. This shortens the manufacturing time and enables stronger bonding between the first and second semiconductor substrates.

### <Delamination Step (Step S4)>

This step can be performed after the bonding step and before the heat treatment step. The application of heat during the delamination step forms a microbubble layer in the hydrogen implanted layer 15, and the microbubble layer is used as a delamination surface to delaminate a portion of the second semiconductor substrate. In other words, the single crystal substrate 13 is delaminated using the hydrogen implanted layer 15 on which the microbubble layer has formed in the single crystal substrate 13 as a delamination surface.

The delamination step is performed in Step S4 of Figure 1. Specifically, the bonded support substrate 11 and single crystal substrate 13 are heated to approximately 800°C or higher. The delamination atmosphere may be at least one of an inert gas atmosphere such as argon (Ar) or nitrogen (N), or a vacuum. The degree of vacuum may be, for example, approximately 1 x 10⁻⁴ to 1 x 10⁻⁶ Pa. The delamination may be performed using rapid thermal annealing (RTA) or a furnace. This allows the single crystal substrate 13 to be separated at the hydrogen implanted layer 15. As shown in the schematic diagram of FIG. 7, a bonded substrate 30 can be formed by bonding a thin single crystal substrate 13, e.g., 0.6 µm thick, to a support substrate 11.

### <Heat Treatment Step (Step S5)>

This step involves heat-treating the bonded substrate. This heat treatment completes the bonded semiconductor substrate 10.

The heat treatment step is performed in step S5 of FIG. 1. In this heat treatment step, the bonded substrate 30, which includes the support substrate 11, amorphous layer 12, and single crystal substrate 13, is heat-treated. The heat treatment temperature may be set so that the temperature of the bonded substrate 30 is between 1500°C and 2200°C, preferably around 1700°C. A heat treatment temperature (i.e., the temperature of the bonded substrate 30) between 1500°C and 2200°C allows the bonded substrate 30 to be heat-treated without any problems and converted into the bonded semiconductor substrate 10. If the heat treatment temperature is below 1500°C, the amorphous layer 12 may remain, potentially reducing the bonding strength of the bonded interface 14. Furthermore, if the heat treatment temperature exceeds 2200°C, the substrate material may sublimate, potentially causing roughness on the surface of the bonded substrate 30.

The heat treatment atmosphere may be at least one of an inert gas atmosphere such as argon (Ar) or nitrogen (N), or a vacuum atmosphere. The degree of vacuum may be, for example, approximately 1×10⁻⁴ to 1×10⁻⁶ Pa. The heat treatment step may be performed in the same furnace as the delamination step. Furthermore, if the heat treatment temperature is maintained for one minute or longer, the amorphous layer 12 can be completely crystallized and eliminated. While there is no particular upper limit on the heat treatment temperature maintenance time, it may be set to, for example, 100 hours in consideration of manufacturing efficiency. For example, the heat treatment temperature maintenance time can be set between one minute and ten hours.

In the heat treatment step of step S5, elements in the amorphous layer 12 migrate during recrystallization, making it more likely that the elements will migrate into pits in the SiC polycrystalline substrate of the support substrate 11 and fill the pits. As a result, it is possible to suppress bonding defects at the bonded interface 14.

The above manufacturing method allows for the production of a bonded semiconductor substrate 10 comprising a first semiconductor substrate and a second semiconductor substrate bonded to the first semiconductor substrate via a bonding interface, the bonded semiconductor substrate 10 being disk-shaped with a diameter of 101.6 to 203.2 mm and having a bonding failure rate of 0.05 pcs/cm² or less at the bonding interface.

Furthermore, in the manufacturing method of the bonded semiconductor substrate 10 of the present invention, after the heat treatment step (step S5), a single crystal layer of a required thickness may be epitaxially grown on the single crystal substrate 13. The resulting epitaxial layer serves as the formation region for various elements of the semiconductor device. The thickness of the epitaxial layer required for the formation of various elements is not particularly limited but is generally 5 µm or more in the case of a SiC bonded semiconductor substrate, for example.

### <Bonding Strength Analysis>

A bonded semiconductor substrate 10 was fabricated by bonding a SiC single crystal substrate and a SiC polycrystalline substrate using the above-described bonded semiconductor substrate manufacturing method. A tensile test was then conducted on the bonded semiconductor substrate 10. Even when the maximum strain of 20 MPa (maximum for the equipment) was applied, the bonded surfaces did not delaminate. This demonstrates that even when the bonding target surfaces have surface roughness that is too high for conventional direct bonding methods (e.g., Patent Literature 2), the bonded semiconductor substrate manufacturing method of the present invention can bond a SiC single crystal substrate and a SiC polycrystalline substrate with sufficient bonding strength to withstand semiconductor processing or the like.

### <Bonding Defect Analysis>

Five 6-inch bonded semiconductor substrates were fabricated by bonding a SiC single crystal substrate and a SiC polycrystalline substrate using the above-described bonded semiconductor substrate manufacturing method of the present invention. The number of bonding defects was determined for each of these substrates using a wafer surface defect inspection system (SICA88, manufactured by Lasertec Corporation). As a comparative example, five 6-inch bonded semiconductor substrates were fabricated by bonding a SiC single crystal substrate and a SiC polycrystalline substrate based on the semiconductor substrate manufacturing method described in Patent Literature 1, and the number of bond defects was similarly confirmed for each of these substrates.

The number of bond defects in the bonded semiconductor substrates fabricated based on the semiconductor substrate manufacturing method described in Patent Literature 1 was 0.1 to 0.5 pcs/cm². On the other hand, the number of bonded transferred portions in the bonded semiconductor substrate 10 fabricated by the bonded semiconductor substrate manufacturing method of the present invention using SiC polycrystalline substrates having bonding target surfaces with the same surface roughness as the bonding target surfaces of the SiC polycrystalline substrates used in the manufacturing method described in Patent Literature 1 was less than 0.05 pcs/cm² for all five substrates.

Furthermore, the number of bonded defects in bonded semiconductor substrates fabricated based on the semiconductor substrate manufacturing method described in Patent Literature 1 had a strong positive correlation with the surface roughness of the bonding target surface of the SiC polycrystalline substrate used as the support substrate, with a tendency for the number of bonded defects to increase as the surface roughness increased. On the other hand, the number of bonded defects in bonded semiconductor substrate 10 fabricated using the bonded semiconductor substrate manufacturing method of the present invention had a weak positive correlation with the surface roughness of the bonding target surface of the SiC polycrystalline substrate used as the support substrate, with no tendency for the number of bonded defects to increase as the surface roughness increased. This confirmed that the occurrence of bonded defects can be reduced by adjusting the thickness of the deposited amorphous layer.

From the above, it can be seen that the bonded semiconductor substrate manufacturing method of the present invention can suppress the occurrence of bonded defects in the bonded semiconductor substrate 10 fabricated.

### <Effects>

In the method for manufacturing a bonded semiconductor substrate of the present invention, by depositing an amorphous layer on at least one of the first bonding target surface 11a of the first semiconductor substrate or the second bonding target surface 13a of the second semiconductor substrate, the atoms constituting the semiconductor are made more mobile. This facilitates the phenomenon of elements migrating into and filling pits in the bonding target surface 11a of a SiC polycrystalline substrate used as the support substrate 11, for example, thereby suppressing the occurrence of bond defects.

### (Summary)

As described above, the present invention can provide a bonded semiconductor substrate and a method for manufacturing a bonded semiconductor substrate that can suppress the occurrence of bond defects due to pits and prevent substrate delamination at the bonded interface, making it industrially useful.

### Reference Signs List

10: Semiconductor Substrate, 11: Support Substrate, 11a: Bonding Target Surface, 12: Amorphous Layer, 13: Single Crystal Substrate, 13a: Bonding Target Surface, 14: Bonded Interface, 15: Hydrogen Implanted Layer, 30: Bonded Substrate, 101: Chamber, 102: Sputtering Target, 103: Sputtering Target

## Claims

1. A method for manufacturing a bonded semiconductor substrate comprising a first semiconductor substrate and a second semiconductor substrate in contact with the first semiconductor substrate, the method comprising:
an amorphous layer deposition step of depositing an amorphous layer having the same composition as the first semiconductor substrate on at least one of a first bonding target surface, which is the surface of the first semiconductor substrate where the first semiconductor substrate is bonded to the second semiconductor substrate, or a second bonding target surface, which is the surface of the second semiconductor substrate where the second semiconductor substrate is bonded to the first semiconductor substrate;
a bonding step of bonding the first bonding target surface and the second bonding target surface after the amorphous layer deposition step to form a bonded substrate having a bonding interface; and
a heat treatment step of heat treating the bonded substrate,
wherein the amorphous layer deposition step and the bonding step are performed in the same apparatus.

2. The method for manufacturing a bonded semiconductor substrate according to claim 1, wherein the first semiconductor substrate and the second semiconductor substrate are made of any of silicon carbide (SiC), silicon (Si), carbon (C), gallium nitride (GaN), aluminum nitride (AlN), gallium oxide (Ga₂O₃), and diamond, and the first semiconductor substrate is polycrystalline and the second semiconductor substrate is single crystal.

3. The method for manufacturing a bonded semiconductor substrate according to claim 1, wherein the amorphous layer deposition step is a step of depositing the amorphous layer on at least one of the first bonding target surface or the second bonding target surface by sputtering.

4. The method for manufacturing a bonded semiconductor substrate according to claim 1 comprising, before the amorphous layer deposition step, an oxide removal step of removing at least one of the oxides on the first bonding target surface and the second bonding target surface.

5. The method for manufacturing a bonded semiconductor substrate according to claim 4, wherein the oxide removal step is a step of removing at least one of the oxides on the first bonding target surface and the second bonding target surface by a sputtering method using at least one of the first bonding target surface and the second bonding target surface as a target.

6. The method for manufacturing a bonded semiconductor substrate according to claim 1, wherein the heat treatment step is a step of maintaining the temperature of the bonded substrate at 1500°C to 2200°C.

7. The method for manufacturing a bonded semiconductor substrate according to claim 1 comprising, before the amorphous layer deposition step, an ion implantation step of implanting hydrogen ions or helium ions into the second bonding target surface to form an ion-implanted layer inside the second semiconductor substrate.

8. The method for manufacturing a bonded semiconductor substrate according to claim 7 comprising a delamination step after the bonding step and before the heat treatment step, wherein the delaminating step is a step of delaminating a portion of the second semiconductor substrate using a microbubble layer formed by heating the ion implanted layer as a delamination surface.

9. The method for manufacturing a bonded semiconductor substrate according to claim 1, wherein the amorphous layer deposition step is a step of depositing an amorphous layer having a thickness of 10 nm to 30 nm.

10. A bonded semiconductor substrate comprising a first semiconductor substrate and a second semiconductor substrate bonded to the first semiconductor substrate via a bonded interface,
wherein the bonded semiconductor substrate is disk-shaped with a diameter of 100 to 210 mm, and
wherein the number of bonding defects at the bonded interface is 0.05 pcs/cm² or less.
